# DEMANDE DE BREVET EUROPEEN

(11) **EP 1 777 735 A2**
(43) Date de publication de la demande: **25.04.2007**
(21) Numéro de dépôt: 06121833.5
(22) Date de dépôt: 05.10.2006
(51) Int. Cl.: H01L 21/20

(54) **Procédé de récyclage d'une plaquette donneuse épitaxiée**

(30) Priorité: 18.10.2005 FR 0510596; 21.03.2006 US 386967
(71) Demandeur: S.O.I.Tec Silicon on Insulator Technologies, 38190 Bernin (FR)
(72) Inventeur: Chhaimi, Nabil, 38130, Echirolles (FR); Guiot, Eric, D2 avenue des trignons, 38570, Goncelin (FR); Reynaud, Patrick, 38400, Saint Martin d'Heres (FR)
(74) Mandataire: Texier, Christian

(57) **Abrégé**

L'invention concerne un procédé de formation d'une structure comportant une couche mince (5, 50) en un matériau semiconducteur sur une plaquette réceptrice (B), comprenant les étapes de :
• préparation (13) de surface par enlèvement d'une épaisseur (Tr) de matière d'une couche (4) formée par croissance épitaxiale sur un substrat support (1) ;
• transfert d'une partie (5, 50) de la couche épitaxiée vers la plaquette réceptrice (B) de manière à former la couche mince sur la plaquette réceptrice, un négatif (A') étant également formé qui comprend le substrat support (1) et une partie restante (40), non transférée, de la couche épitaxiée,

caractérisé en ce que l'épaisseur (Tr) enlevée par ladite étape de préparation de surface est adaptée pour que l'application au négatif (A') de ladite étape de préparation de surface autorise la formation d'une nouvelle couche mince à partir de la partie restante (40) d'épaisseur réduite par l'étape de préparation de surface.

## Description

La présente invention concerne d'une manière générale la formation d'une structure comportant une couche mince en un matériau semiconducteur sur une plaquette réceptrice, la couche mince étant transférée d'une plaquette donneuse vers la plaquette réceptrice.

L'invention vise à permettre le recyclage de la plaquette donneuse après transfert de la couche mince. L'invention vise plus précisément à permettre le recyclage d'une plaquette donneuse comprenant avant transfert un substrat support sur lequel repose une couche formée par croissance épitaxiale, la couche mince étant formée à partir d'une partie de ladite couche épitaxiée, et la plaquette donneuse comprenant, après transfert, le substrat support et la partie restante, non prélevée, de ladite couche épitaxiée.

La plaquette donneuse à recycler est typiquement un négatif issu d'un procédé de transfert comprenant une étape de mise en contact de la plaquette donneuse avec une plaquette réceptrice et une étape de détachement au niveau d'une zone de fragilisation créée, notamment par implantation ionique, dans l'épaisseur de la couche épitaxiée.

Le détachement est par exemple réalisé par application d'une contrainte thermique éventuellement combinée à une contrainte mécanique (cas du procédé SMART CUT^{®} en particulier), ou par application d'une contrainte mécanique seulement (par exemple procédé ELTRAN^{®} qui utilise un jet de fluide sous pression au niveau d'une couche fragilisée poreuse), ou encore par d'autres moyens (utilisation d'ultrasons, etc...).

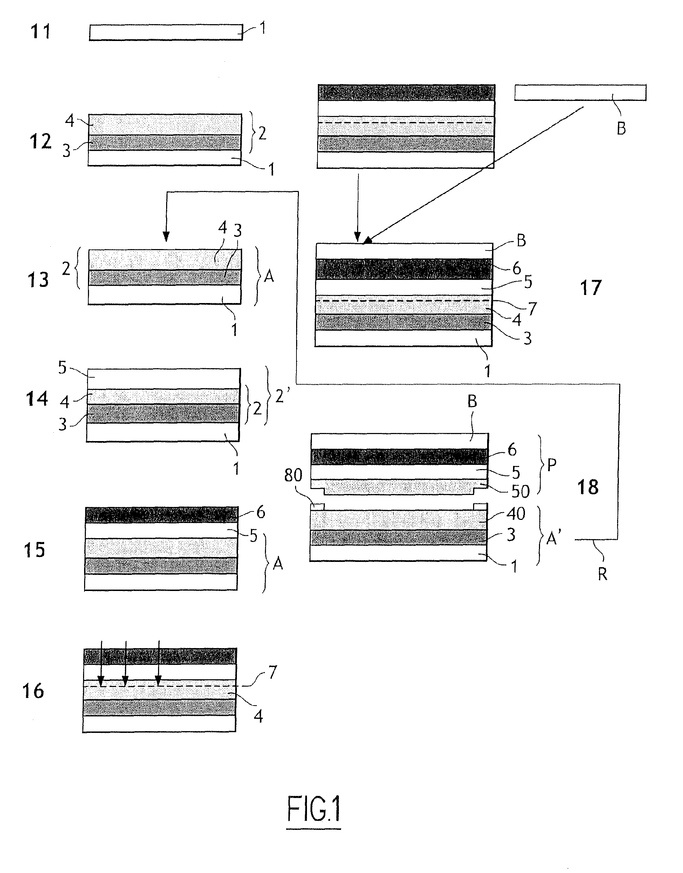

Les étapes principales d'une forme de procédé de transfert avec détachement au niveau d'une zone de fragilisation sont exposées sur la figure 1.

Cette figure fait apparaître une succession d'étapes 11 à 18, qui permettent de fabriquer à partir d'un substrat support 1 et d'une plaquette réceptrice B une structure de type SeOl (selon l'acronyme anglo-saxon de Semiconductor On Insulator pour Semiconducteur sur Isolant), et produisent également un reliquat A' issu de la plaquette donneuse A, ce reliquat correspondant au « négatif » évoqué ci-dessus.

Partant de l'étape 11, dans laquelle on dispose d'un substrat support 1 (en silicium dans l'exemple ici présenté), on précède en 12 à une étape visant à former, par croissance épitaxiale sur le substrat support, une structure 2 comprenant une couche ou une superposition de couches.

Dans l'exemple représenté sur la figure 1, la structure épitaxiée 2 comporte une couche tampon 3, et une couche 4 sur la couche tampon 3. On parle également de structure hétéro-épitaxiale pour qualifier ce type de structure.

La couche tampon 3, située sur le substrat support 1, permet de présenter à sa surface un paramètre de maille sensiblement différent du paramètre de maille du substrat support 1. La couche tampon est par exemple une couche de SiGe, à concentration en Ge augmentant progressivement depuis l'interface avec le substrat support en Si et présentant par conséquent un paramètre de maille se modifiant progressivement pour établir la transition entre les deux paramètres de maille.

Cette modification progressive du paramètre de maille est par exemple réalisée de manière progressive dans l'épaisseur de la couche tampon.

Ou elle peut encore être réalisée par « étages », chaque étage étant une couche mince avec un paramètre de maille sensiblement constant et différent de celui de l'étage inférieur, de sorte à modifier de façon discrète le paramètre de maille étage par étage.

La couche 4 est située sur la couche tampon 3 et présente le paramètre de maille en surface de la couche tampon, différent de celui du substrat support. La couche 4 est typiquement en un matériau relaxé par la couche tampon 3, ici en SiGe relaxé.

La couche tampon 3 et la couche 4 sont formées par croissance épitaxiale sur le substrat support 1, en utilisant les techniques connues telles que les techniques CVD et MBE (acronymes respectifs de « Chemical Vapor Deposition » et « Molecular Beam Epitaxy »).

La couche 4 peut être réalisée in situ, directement en continuation de la formation de la couche tampon 3 sous-jacente. La croissance de la couche 4 peut également être réalisée après une légère étape de finition de la couche tampon sous-jacente.

Les étapes 11 et 12 permettent ainsi de former une plaquette donneuse appelée « fresh » par la suite, car non issue d'un recyclage.

On procède ensuite à l'étape 13 à une étape de préparation de la surface de la structure épitaxiée 2 (ici de la surface de la couche 4). Cette étape de préparation de la surface de la couche est typiquement mise en oeuvre en réalisant un enlèvement de matière en surface de la plaquette « fresh », par exemple sous la forme d'un polissage mécano-chimique de type CMP.

L'étape 14 est une étape optionnelle relative à la formation, par croissance épitaxiale (de manière sensiblement identique à celle décrite précédemment pour la formation de la couche 4), d'une surcouche 5 en surface de la plaquette donneuse A, c'est-à-dire en surface de la couche 4 en SiGe relaxé dans l'exemple ici présenté. Dans ce cas de figure, on a formé sur le substrat support 1 une structure hétéro-épitaxiée 2' comprenant la couche tampon 3, la couche 4 et la surcouche 5.

La surcouche 5 a avantageusement un paramètre de maille sensiblement identique à celui du matériau relaxé de la face libre de la structure 2 ; il s'agit typiquement dans l'exemple présenté d'une couche de Si contraint, en surface de la couche 4 en SiGe relaxé.

La surcouche 5 peut également comprendre une première couche en en SiGe relaxé, ainsi qu'une seconde couche en Si contraint arrangée sur ladite première couche. En d'autres termes, une épitaxie de SiGe est réalisée avant de déposer, également par épitaxie, une couche de Si contraint.

Une application possible que l'on fera de la plaquette donneuse A est celle d'un prélèvement d'une couche mince formée à partir d'une partie de la couche 4 de la structure 2 épitaxiée sur le substrat support 1, et, le cas échéant, de la surcouche 5 formée en surface de la structure 2 lors de l'étape optionnelle 14.

On procède en 15 à une étape facultative de formation d'une couche d'oxyde en surface de la plaquette donneuse et/ou de la plaquette réceptrice pour former une couche d'oxyde 6, cette étape étant liée au produit final que l'on désire obtenir, ici une structure SeOl qui comprend une couche d'isolant correspondant à la couche d'oxyde.

On précède en 16 à une étape d'implantation de la plaquette donneuse par des ions (par exemple hydrogène et/ou hélium), afin de former une zone de fragilisation 7 dans l'épaisseur de la structure épitaxiée 2, 2', et plus précisément dans l'épaisseur de la couche 4 dans l'exemple retenu.

L'étape 17 qui suit correspond au collage de la plaquette donneuse A oxydée avec la plaquette réceptrice B.

Par « collage », on entend une mise en contact intime et permanente, qui peut correspondre à une adhésion moléculaire, et qui peut également être renforcée en disposant entre les surfaces en regard de la plaquette donneuse oxydée et de la plaquette réceptrice un produit destiné à faciliter l'adhésion de ces deux éléments. En tout état de cause, le collage est généralement précédé d'un nettoyage de ces surfaces que l'on désire coller.

Lors de l'étape 18, on procède au détachement de l'ensemble ainsi formé par le collage, au niveau de la zone de fragilisation 7. Comme on l'a dit, ce détachement peut être par exemple réalisé en appliquant à cet ensemble une contrainte thermique et/ou mécanique.

On produit ainsi, comme cela est représenté à l'étape 18:
➢ d'une part, un positif P correspondant à une structure SeOl, dans laquelle la couche superficielle correspond à la couche de la plaquette donneuse A qui a été délimitée par la zone de fragilisation (comprenant une partie 50 de la couche 4, et le cas échéant la surcouche 5 formée à l'étape optionnelle 14). En d'autres termes la couche mince transférée correspond à la partie de la structure 2 (le cas échéant 2') délimitée par la zone de fragilisation, du côté mis en contact avec la plaquette réceptrice B.
   Ainsi lorsque les étapes 14 et 15 ont été réalisées, on obtient un positif P comprenant la plaquette réceptrice B sur laquelle sont successivement empilées la couche d'oxyde 6, la surcouche 5 en Silicium contraint et la partie transférée 50 de la couche 4 en SiGe relaxé. La partie transférée 50 est alors typiquement retirée de manière à obtenir au final une structure de type sSOl (selon l'acronyme anglo-saxon « Strained Silicon On Insulator » pour silicium contraint sur isolant).
   Lorsque l'étape 14 n'a pas été réalisée, on obtient un positif comprenant la plaquette réceptrice B sur laquelle sont successivement empilées la couche d'oxyde 6 et la partie transférée 50 de la couche 4 en SiGe relaxé. On réalise alors typiquement un dépôt par croissance épitaxiale d'une couche en Silicium sur la couche 50 (faisant alors office de substrat de croissance), et le silicium de la couche déposée étant alors contraint par le SiGe relaxé de la couche 50 sous jacente. On obtient au final une structure de type SGOI (selon l'acronyme anglo-saxon « Strained silicon on SiGe On Insulator » pour silicium contraint sur SiGe sur isolant).
➢ d'autre part, un négatif A' correspondant à la partie de la plaquette donneuse qui n'est pas demeurée solidaire de la plaquette réceptrice B, et comprenant par conséquent le substrat support 1 et la partie restante 40, non transférée, de la structure épitaxiée 2,2'. En l'occurrence, ladite partie restante 40 correspond à la partie de la couche 4 qui n'est pas demeurée solidaire de la plaquette réceptrice B (car sous jacente à la zone de fragilisation 7 au niveau duquel le détachement a été réalisé).

Dans le cadre du prélèvement d'une couche mince à partir d'une plaquette donneuse, la couche mince étant formée d'une partie d'une couche de la plaquette donneuse déposée par épitaxie, et notamment dans le cadre des exemples d'application donnés précédemment (formation d'une structure sSOI ou SGOI), aucun recyclage du négatif n'est généralement mis en oeuvre.

Il découle de cette absence de recyclage du négatif A', que pour former une (nouvelle) plaquette donneuse (en vue d'opérer un nouveau prélèvement d'une couche mince), on doit nécessairement utiliser un nouveau substrat support et former une nouvelle plaquette « fresh » en renouvelant les étapes 11 et 12 pour déposer, par croissance épitaxiale, une structure 2 comprenant une couche ou une superposition de couches sur le substrat support 1.

On conçoit qu'une telle absence de recyclage est particulièrement préjudiciable dans la mesure où le négatif A' n'est pas réutilisé et en ce que l'on doit répéter les opérations complexes, longues et coûteuses de formation de la structure épitaxiée 2 sur un substrat support.

Une technique a cependant été proposée par la Demanderesse afin de permettre le recyclage d'une plaquette donneuse ayant servie au prélèvement d'une couche mince, la couche mince étant formée d'une partie d'une structure épitaxiée sur le substrat support de la plaquette donneuse.

On pourra ainsi se reporter au document US2004/0152284 qui traite du recyclage d'une plaquette donneuse pour laquelle la structure épitaxiée comprend un empilement de couches de SiGe épitaxiées sur un substrat en Si. Ce document propose de placer une couche spécifique dans l'empilement des couches, à savoir une couche dite couche d'arrêt jouant le rôle d'une barrière à une attaque de matière. La présence de cette couche d'arrêt permet alors de réaliser un enlèvement de matière sélectif (notamment par gravure chimique sélective) lors d'un enlèvement de matière réalisé au cours du recyclage. En référence aux figures 7a-7f de ce document, la couche d'arrêt 3 permet de réaliser un enlèvement sélectif de la partie restante 7 après prélèvement de la structure épitaxiée I. Suite à cet enlèvement de matière sélectif, il s'avère nécessaire de réaliser une opération d'épitaxie spécifique afin de reformer une structure similaire à la structure épitaxiée d'origine (épitaxie de la couche 4') et de recréer ainsi une plaquette pouvant servir de plaquette donneuse.

Cette approche présente toutefois un certain nombre d'inconvénients.

Elle nécessite en effet la réalisation d'une épitaxie spécifique pour former la couche d'arrêt.

Elle nécessite en outre la réalisation d'une étape d'enlèvement de matière sélectif, ainsi qu'une étape d'épitaxie supplémentaire pour reformer la structure épitaxiée à partir de laquelle la couche mince est prélevée.

Or le coût d'une étape d'épitaxie est relativement important, notamment du fait de l'utilisation d'équipements spécifiques, de l'utilisation de gaz spéciaux, ou encore du fait d'un temps de réalisation relativement long.

Cette approche n'est donc pas totalement satisfaisante et il existe donc un besoin pour une technique de recyclage d'un négatif ayant servi au prélèvement d'une couche mince épitaxiée qui soit plus simple et moins coûteuse.

L'invention a pour objectif de répondre à ce besoin, et vise en particulier une technique de recyclage qui s'intègre aisément dans le processus de fabrication des structures SeOl selon un procédé de transfert de type SMARTCUT®.

L'invention propose à cet effet un procédé de formation d'une structure comportant une couche mince en un matériau semiconducteur sur une plaquette réceptrice, comprenant les étapes de :
- préparation de surface par enlèvement d'une épaisseur de matière d'une couche formée par croissance épitaxiale sur un substrat support ;
- transfert d'une partie de la couche épitaxiée vers la plaquette réceptrice de manière à former la couche mince sur la plaquette réceptrice, un négatif étant également formé qui comprend le substrat support et une partie restante, non transférée, de la couche épitaxiée,
caractérisé en ce que l'épaisseur enlevée par ladite étape de préparation de surface est adaptée pour que l'application au négatif de ladite étape de préparation de surface autorise la formation d'une nouvelle couche mince à partir de la partie restante d'épaisseur réduite par l'étape de préparation de surface.

Certains aspects préférés, mais non limitatifs, de ce procédé sont les suivants :
- l'enlèvement de matière est un enlèvement non sélectif;
- l'enlèvement de matière est un polissage, par exemple de type CMP ;
- l'épaisseur retirée par l'enlèvement de matière est comprise entre 0,1 et 4 m;
- avant d'être utilisé pour l'étape de préparation de surface, le négatif est soumis à une étape visant à éliminer une partie d'une couronne de prélèvement correspondant à une partie périphérique de la couche transférée qui est restée solidaire du négatif;
- l'épaisseur retirée par l'enlèvement de matière est comprise entre 0,1 et 2 m;
- l'élimination de la couronne est réalisée par polissage des bords du négatif;
- l'élimination de la couronne est réalisée en mettant en oeuvre un enlèvement localisé de matière du négatif, par exemple une gravure plasma localisée ;
- une plaquette dite donneuse comprend le substrat support sur lequel la couche a été formée par croissance épitaxiale et le transfert comprend les étapes consistant à former une zone de fragilisation dans l'épaisseur de la couche épitaxiée, à mettre en contact intime la plaquette donneuse et la plaquette réceptrice et à détacher au niveau de la zone de fragilisation,
caractérisé en ce que suite à sa formation, le négatif est soumis à une étape de traitement thermique de dégazage destinée à faire éclater des microcavités subsistant dans le négatif;
- le traitement thermique de dégazage est un recuit mené avec un budget thermique supérieur à celui d'un traitement thermique mis en oeuvre pour réaliser l'étape de détachement ;
- le recuit est mené à une température supérieure à 700 °C ;
- une étape de nettoyage de la surface du négatif est réalisée après le traitement thermique de dégazage;
- le nettoyage est du type RCA ;
- une étape de suppression de couche d'oxyde est réalisée suite au nettoyage;
- la suppression de couche d'oxyde est réalisée par gravure chimique de type H F ;
- la couche épitaxiée étant une couche en SiGe relaxé formée par croissance épitaxiale sur une couche tampon en SiGe, ladite couche tampon étant formée par croissance épitaxiale sur un substrat support en Si et présentant une composition en Ge augmentant progressivement depuis l'interface avec le substrat support, la couche mince transférée comprenant une partie de ladite couche en SiGe relaxé, au cours de l'étape de préparation de surface appliquée au négatif, on réalise un polissage CMP au cours duquel la surface de la partie restante, non prélevée, de la couche en SiGe relaxée est polie à l'aide d'un tissu de polissage présentant une compressibilité comprise entre 2 et 15% et d'un liquide abrasif contenant au moins 20% de particules de silice ayant une taille comprise entre 70 et 210 nm;
- la couche épitaxiée étant en SiGe relaxé, le procédé comporte, suite à l'étape de préparation de surface, une étape visant à former, par croissance épitaxiale, une surcouche comprenant une couche de Si contraint sur la couche supérieure en SiGe relaxé.

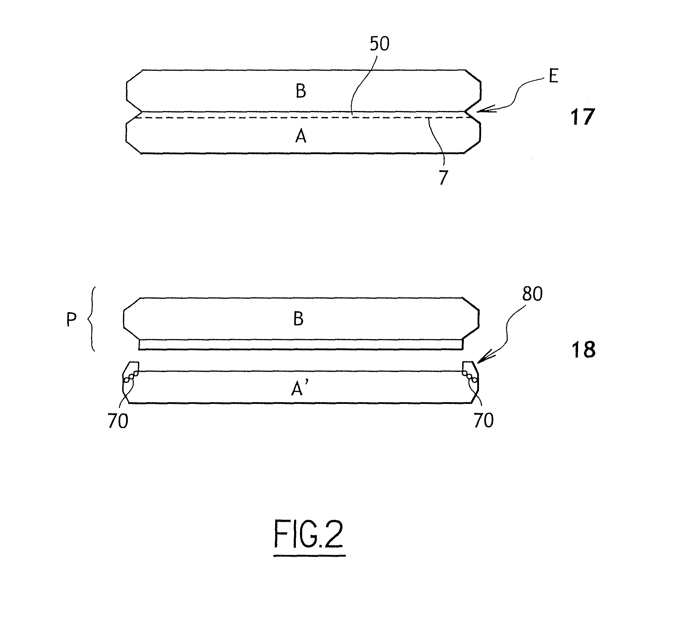

D'autres aspects, buts et avantages de la présente invention apparaîtront mieux à la lecture de la description détaillée suivante de formes de réalisation préférées de celle-ci, donnée à titre d'exemple non limitatif, et faite en référence aux dessins annexés sur lesquels, outre la figure 1 déjà commentée, la figure 2 illustre le transfert de la couche mince.

En référence à la figure 2, on a représenté la manière dont s'effectue le détachement de l'étape 18, suite au collage de l'étape 17, et notamment la raison de la formation d'une couronne 80 (zone non transférée) en surface du négatif A'.

On constate sur cette figure 2 (étape 18) que le détachement de la plaquette donneuse A et de la plaquette réceptrice B n'est pas réalisé selon la totalité des surfaces en regard de ces deux éléments.

En réalité, les bords de ces éléments, qui apparaissent comme à angles vifs sur les représentations très schématiques de la figure 1 sont chanfreinés.

Ceci correspond à un standard des plaquettes fines de matériaux semiconducteurs, et permet en particulier de limiter l'exposition des plaquettes à des endommagements pouvant résulter de chocs de bords non chanfreinés.

Chaque plaquette manipulée comporte ainsi un chanfrein qui démarre typiquement à 1,5 mm du bord de la tranche. Ce chanfrein forme ainsi une zone annulaire périphérique des plaquettes.

On précise que les plaquettes ont en vue de dessus une forme générale de disque. On précise également que les chanfreins représentés à titre illustratif sur la figure 2 ne sont pas nécessairement représentatifs d'une échelle réaliste.

Cette figure montre (voir étape 17 en particulier) que l'étape d'implantation (ou de manière plus générale l'étape de formation d'une zone de fragilisation) a généré une zone de fragilisation 7 qui s'étend dans l'épaisseur de la plaquette donneuse A à une profondeur sensiblement constante sous sa surface qui est en contact avec la plaquette réceptrice B, et ce d'un bord à l'autre de la plaquette A.

Ainsi, la zone de fragilisation 7 s'étend jusqu'à la périphérie de la plaquette A, et débouche sur cette périphérie au niveau du chanfrein de la plaquette A.

Il existe ainsi, comme représenté en référence à l'étape 17 sur la figure 2, une région périphérique de l'ensemble formé par la plaquette A et la plaquette réceptrice B en forme d'encoche annulaire E, d'une profondeur de l'ordre de 1,5 mm (on rappelle que les dessins ne sont pas à l'échelle) et entourant cet ensemble.

Et la zone de fragilisation 7 débouche dans cette région d'encoche E.

Lors du détachement (étape 15), ce n'est en fait pas toute la couche 50 de la plaquette A qui a été délimitée par la zone de fragilisation 7 qui est détachée du reste de la plaquette A (pour former le positif P).

En réalité, une couronne annulaire 80, correspondant à la partie périphérique de la couche 50, demeure solidaire de la plaquette A, et s'étend jusqu'à sa périphérie.

La partie de la couche 50 qui a effectivement été détachée du reste de la plaquette correspond en effet seulement à la région de cette couche qui était collée à la plaquette réceptrice B.

Et du fait de la présence de l'encoche annulaire E, cette région est une région centrale - qui laisse donc sur la plaquette A la couronne 80 dont la largeur est comparable à la profondeur de l'encoche E.

Pour recycler le négatif issu du procédé de transfert (ce négatif correspondant à l'élément A' sur la figure 2, étape 18), il est en particulier nécessaire d'éliminer cette couronne saillante 80.

Et il est également nécessaire d'améliorer l'état de surface du négatif au niveau de sa région centrale, car le détachement a généré des perturbations de surface.

On précise que la partie périphérique 70 (cf. figure 2) de la zone de fragilisation 7 demeure dans l'épaisseur de la couronne 80.

Et lors du détachement, cette partie périphérique a généré des microcavités ou des cavités, qui demeurent enterrées dans l'épaisseur de la couronne.

Et il est nécessaire d'éliminer ces cavités, car si de telles microcavités demeurent enterrées dans le négatif, elles sont susceptibles de se dilater ou d'exploser lorsque la plaquette recyclée à partir du négatif sera exposée à d'autres traitements thermiques.

Une telle explosion projetterait des particules sous la surface du négatif, ce qui ne permettrait pas de le réutiliser dans de bonnes conditions.

Or il serait souhaitable de pouvoir réutiliser le négatif en l'exposant à de tels traitements thermiques (par exemple pour le recouvrir d'oxyde - étape 14, ou encore pour effectuer un détachement au niveau d'une zone de fragilisation - étape 18).

Il est donc nécessaire pour mettre en oeuvre le négatif à nouveau de:
- supprimer la couronne 80,
- supprimer la partie périphérique 70 de la zone de fragilisation qui est demeurée enterrée dans le négatif,
- améliorer l'état de surface de l'ensemble du négatif.

Suite à l'obtention du négatif A', un traitement thermique dudit négatif A' peut être réalisé afin de faire éclater les microcavités du bord du négatif (correspondant à la partie 70 de la zone de fragilisation). Ce traitement thermique est également dénommé traitement thermique de dégazage de la couronne.

Ce traitement thermique peut être un recuit dont le budget thermique est suffisant pour éliminer l'ensemble de ces défauts de bord.

Ce budget thermique doit donc en particulier être supérieur aux budgets des traitements thermiques que la plaquette donneuse qui a généré le négatif a subis (notamment recuit de détachement du négatif à partir de la plaquette donneuse A). Ces traitements n'ont en effet pas permis de faire éclater les microcavités.

Ce recuit visant à éliminer les microcavités peut ainsi être un recuit mené à une température supérieure aux températures auxquelles le négatif a été exposé lors de sa constitution (c'est à dire en particulier à une température supérieure à celle du recuit ayant permis le détachement).

Ce recuit peut par exemple être mené à une température supérieure à 700 °C.

Ce recuit peut être mené en atmosphère neutre, ou oxydante (argon, azote, ...).

Ce recuit peut également être mené sous une atmosphère « lissante » permettant de réduire la rugosité de surface du négatif, par exemple sous une atmosphère contenant de l'hydrogène.

A l'issue du traitement thermique de dégazage, on peut procéder à un nettoyage de la surface du négatif, par exemple en réalisant un nettoyage du type RCA.

Le nettoyage RCA consiste typiquement à traiter les surfaces à coller, successivement avec :
- un premier bain d'une solution, connue sous l'acronyme "SC1" (d'après la terminologie anglo-saxonne de "Standard Clean 1" qui signifie "solution de nettoyage standard 1 "), et qui comprend un mélange d'hydroxyde d'ammonium (NH₄OH), de peroxyde d'hydrogène (H₂O₂) et d'eau déionisée,
- un second bain d'une solution, connue sous l'acronyme "SC2" (d'après la terminologie anglo-saxonne de "Standard Clean 2" qui signifie "solution de nettoyage standard 2"), et qui comprend un mélange d'acide chlorhydrique (HCl), de peroxyde d'hydrogène (H₂O₂) et d'eau déionisée.

Le premier bain est destiné principalement à retirer les particules isolées présentes à la surface de la plaquette et à rendre les surfaces hydrophiles, tandis que le second bain est plutôt destiné à retirer les contaminations métalliques.

A l'issue de ce nettoyage, on peut procéder à un enlèvement de l'oxyde qui recouvre une partie de la surface du négatif (typiquement la couronne et la face arrière comme on l'a vu - et en outre sur toute la surface du négatif si le traitement thermique de dégazage qui précédait a été mené sous atmosphère oxydante).

Ceci peut être fait par attaque chimique, par exemple par attaque avec du HF.

On précise que dans le cas où le négatif est issu d'une plaquette donneuse n'ayant pas été oxydée, cette étape peut être omise.

L'invention propose un procédé de transfert de type de celui illustré sur la figure 1 dans lequel un négatif A' est utilisé en tant que plaquette donneuse pour l'étape de préparation de surface.

En d'autres termes, le négatif A' est « inséré » dans le procédé de transfert existant au niveau de l'étape 13 en lieu et place d'une plaquette « fresh ». La flèche R sur la figure 1 illustre cette « insertion ».

Un tel négatif A' est du type de celui formé à l'issue de l'étape de détachement 18 représenté sur la figure 1. Comme vu précédemment, ce négatif a avantageusement été soumis, suite à sa formation et avant d'être utilisé en tant que plaquette donneuse pour l'étape de préparation de surface, à un traitement thermique de dégazage accompagné ou non d'un nettoyage et d'une désoxydation.

Dans le cadre du procédé selon l'invention, l'étape de préparation de surface est ainsi mise en oeuvre sur un négatif A', c'est-à-dire sur la partie restante 40, non prélevée, de la structure 2 (couche ou superposition de couches) épitaxiée sur le substrat support 1.

L'épaisseur retirée par l'étape de préparation de surface est plus particulièrement prévue pour que l'application au négatif de ladite étape de préparation de surface réduise l'épaisseur de ladite partie restante de manière à autoriser le prélèvement d'une nouvelle couche mince directement à partir de ladite partie restante d'épaisseur réduite.

Il s'agit notamment de consommer une épaisseur suffisante pour supprimer la couronne et améliorer l'état de surface de la partie restante de la couche épitaxiée 4.

L'étape de préparation de surface appliquée au négatif est du même type (notamment réalisé avec les mêmes équipements) que celle classiquement appliquée à une plaquette « fresh ». L'invention permet donc de réaliser le recyclage de manière transparente par l'adaptation de l'étape classique de préparation de la surface d'une plaquette donneuse « fresh ». Cette étape, déjà présente dans le procédé existant, est en effet uniquement adaptée (notamment en vue d'une consommation d'épaisseur plus importante) pour permettre le recyclage.

En d'autres termes, il s'avère ainsi possible de réintégrer directement le négatif A' résultant de l'étape 18 de détachement dans le processus standard de transfert d'une couche mince (par exemple pour fabrication d'une structure SeOl selon le procédé SMARTCUT®) et plus précisément de le réintégrer tel quel pour lui faire subir directement l'étape 13 de préparation de surface, sans passer par la coûteuse étape 12 d'épitaxie.

Cette étape de préparation de surface permet en outre de rendre l'état de surface de la partie restante directement compatible avec le prélèvement d'une nouvelle couche mince.

Au cours d'une étape de préparation de surface d'une plaquette donneuse « fresh », on vient typiquement retirer une épaisseur de l'ordre de 20 nm de manière à préparer la surface de la structure épitaxiée 2. L'épaisseur de la couronne étant quant à elle typiquement de l'ordre de 200 nm, on conçoit donc que pour s'appliquer au négatif, l'étape classique de préparation de surface est adaptée pour consommer une épaisseur plus importante.

Un avantage du procédé selon l'invention réside donc dans le fait que le négatif peut être inséré dans la ligne existante de fabrication. Il n'est donc pas nécessaire de mettre en oeuvre, au contraire notamment de la solution présentée dans le document US2004/0152284 discuté précédemment, une technique particulière pour le recyclage du négatif. En particulier, aucune opération supplémentaire, par exemple de type gravure sélective ou épitaxie, n'est réalisée.

On notera que l'on s'affranchit ainsi des inconvénients liés à l'enlèvement de matière sélectif (typiquement par attaque chimique), cela en particulier lorsque l'invention est mise en oeuvre avec des équipements standards (alors que l'attaque chimique nécessite un dispositif particulier).

Afin de réaliser l'enlèvement de matière, on réalise par exemple un polissage de la partie restante 40 (cf. figure 1) de la couche 4.

Il s'agit notamment là de polir la surface du négatif A' pour éliminer la couronne 80.

Ce polissage peut également permettre d'abaisser la rugosité de l'ensemble de la surface du négatif au niveau désiré pour permettre le transfert d'une nouvelle couche mince. Il s'agit typiquement là d'abaisser la rugosité à un niveau inférieur à 2 angströms RMS en 10*10 m² AFM.

On notera que de manière avantageuse, la partie 70 de la zone de fragilisation 7 ayant été « neutralisée » par le traitement thermique de dégazage qui a fait éclater les microcavités, cette partie 70 n'est pas susceptible de poser au polissage des problèmes susceptibles d'être rencontrés en l'absence d'un tel traitement thermique préalable (éclatement lors du polissage, ou microcavités qui restent enterrées et qui risquent d'éclater lors de traitements thermiques ultérieurs).

On précise que le polissage de la couronne est facilité par le fait que les microcavités de la partie 70 de la zone de fragilisation aient éclaté, cet éclatement fragilisant la couronne et facilitant son enlèvement lors du polissage.

L'étape de préparation de surface vient retirer une épaisseur Tr de la partie restante 40.

Pour autoriser le transfert d'une nouvelle couche mince à partir de la partie restante d'épaisseur réduite, l'épaisseur minimale à retirer dépend notamment de l'épaisseur de la couronne et de l'état de surface à atteindre. L'épaisseur maximale à retirer doit quant à elle être telle que la partie restante d'épaisseur réduite présente une épaisseur supérieure à une épaisseur minimum Tm en dessous de laquelle on ne peut plus réaliser le transfert d'une couche mince d'épaisseur Ts.

Considérons une couche 4 d'épaisseur Ti (comprise entre 1 et 50 µm) à l'issue de l'étape 13 de préparation de surface d'une plaquette donneuse « fresh » A. Suite aux étapes d'implantation 16 et de détachement 17, la partie restante 40 de la couche 4 présente une épaisseur Ti-Ts, Ts représentant l'épaisseur de la couche mince 50 prélevée.

Suite à la préparation de surface du négatif, la partie restante 40 présente une épaisseur Ti - (Ts + Tr).

Ainsi, à chaque cycle de recyclage, une épaisseur (Ts+Tr) est retirée, résultant du prélèvement (Ts) et de l'enlèvement de matière pour éliminer la couronne et préparer la surface (Tr).

Il est ainsi possible d'évaluer le nombre N de recyclages possibles selon Ti - N. (Ts + Tr) > Tm On précisera un exemple de ce nombre N dans le cadre de la présentation d'un cas particulier d'application du procédé selon l'invention.

On précise que dans le cadre des exemples d'applications ici présentés, l'épaisseur minimum Tm est typiquement de l'ordre de 0,4 m.

Dans le cas où l'épaisseur minimum Tm est atteinte (que ce soit à l'issue de plusieurs cycles de recyclage, voire même à l'issue d'un seul cycle de recyclage), on notera qu'il est possible de réaliser de nouveau un dépôt par croissance épitaxiale de la couche 4, mais cela sans avoir à recréer la couche tampon 3 sous-jacente. Il s'ensuit un gain en terme de temps et de coût sur l'étape de croissance épitaxiale présentée sous la référence 12 sur la figure 1.

Bien entendu, un tel nouveau dépôt par croissance épitaxiale de la couche 4 peut également être réalisé avant que l'épaisseur minimum Tm ne soit atteinte. Ce nouveau dépôt peut par exemple être réalisé de manière systématique après chaque étape d'enlèvement de matière appliquée au négatif, pour venir recréer une couche 4 d'épaisseur Ti.

On rappelle que dans le cadre de la fabrication d'une structure sSOl, on a recours à l'étape 14 de formation de la surcouche 5. Comme on l'a vu précédemment, cette étape peut consister à réaliser une épitaxie d'une première couche en SiGe relaxé, suivi d'une épitaxie d'une couche en Si contraint arrangée sur ladite première couche. Dans un tel cas de figure, et de manière similaire au nouveau dépôt de la couche 4 discuté ci-dessus, on peut venir épitaxier, suite à l'étape de préparation de surface appliquée au négatif, ladite première couche en SiGe relaxé, avant de réaliser un nouveau dépôt d'une couche en Si contraint.

Revenant à la description de l'étape de préparation de surface, le polissage peut être mené de manière classique comme un polissage d'enlèvement de matière non sélectif, en utilisant une tête de polissage rotative, tournant en regard d'un plateau de polissage également rotatif (selon un axe de rotation qui peut être parallèle à l'axe de rotation de la tête), le plateau de polissage étant revêtu d'un tissu de polissage, le négatif étant plaqué entre la tête et le plateau en présentant au tissu recouvrant le plateau sa surface à polir.

De manière avantageuse, le polissage peut être un polissage adapté pour réaliser un enlèvement de matière d'une structure hétéro-épitaxiale, par exemple un polissage du type de celui décrit par la Demanderesse dans sa demande internationale de brevet PCT/EP2004/006186 déposée le 8 Juin 2004, et non encore publiée.

Il s'agit typiquement de mettre en oeuvre un polissage mécano-chimique de type CMP (acronyme anglo-saxon de Chemical Mechanical Polishing) à l'aide d'un tissu de polissage présentant une compressibilité comprise entre 2 et 15% et d'un liquide abrasif (« slurry ») contenant au moins 20% de particules de silice ayant une taille comprise entre 70 et 210 nm.

Selon un mode de réalisation particulièrement avantageux de l'invention, lorsque l'étape de préparation de surface est appliquée à un négatif, on met en oeuvre avant ladite étape de préparation de surface, une étape visant à éliminer au moins une partie de la couronne.

La suppression préalable d'une partie au moins de la couronne permet en particulier de mettre en oeuvre un polissage réduit par rapport au cas où la couronne n'est pas, au moins en partie, préalablement éliminée.

A titre d'exemple, l'épaisseur Tr consommée au cours de l'étape de préparation de surface de la partie restante 40 de la structure épitaxiée est typiquement de l'ordre de 0,1 à 4 m lorsqu'on ne réalise pas une suppression préalable de la couronne. Cette épaisseur Tr est de l'ordre de 0,1 à 2 m lorsque l'on réalise une suppression préalable de la couronne.

On note ici que l'épaisseur Tr, dans le mode de réalisation selon lequel on ne réalise pas une suppression préalable de la couronne, est typiquement supérieure à l'épaisseur de la couronne. La réalisation d'une CMP en périphérie de plaquette (là où se trouve la couronne) est en effet généralement difficile, et il s'avère donc nécessaire de consommer une épaisseur plus importante que celle de la couronne.

L'intérêt de l'étape de suppression de la couronne réside dans le fait que l'épaisseur à retirer lors de la préparation de surface du négatif est limitée. Du fait de cette consommation d'épaisseur plus faible, le nombre de recyclages possibles se trouve potentiellement accru.

Par ailleurs, l'épaisseur à consommer est alors plus proche de celle qui est consommée au cours de l'étape classique de préparation de la surface d'une plaquette « fresh ». Ce mode de réalisation avantageux de l'invention présente donc l'avantage de ne solliciter qu'une légère adaptation du procédé de l'état de la technique.

L'élimination de la couronne peut être réalisée:
- par une technique dite de « edge polish » adaptée pour diminuer l'épaisseur de la couronne par polissage des bords du négatif. Selon cette technique, on applique différents plateaux de polissage, chaque plateau étant recouvert d'un tissu de polissage sur lequel un liquide abrasif est envoyé. On peut par exemple utiliser un plateau supérieur Ps incliné de 15° par rapport à la surface du négatif, et un plateau inférieur Pi incliné de 22°. On comprend bien que par réglage de l'angle, on peut pénétrer plus ou moins profondément à l'intérieur de la plaquette. Outre la consommation de l'épaisseur de la couronne, cette technique permet également de reconstituer un chanfrein en bord de plaquette.
- par une technique d'enlèvement localisé de matière, par exemple selon une technique de type DCP (acronyme anglo-saxon de « Dry Chemical Polishing » pour Polissage Chimique à Sec). A titre d'exemple on peut réaliser une gravure plasma localisée, en venant positionner un masque sur la partie centrale du négatif, et en appliquant une gravure plasma (H₂ ou O₂) de manière à consommer de l'épaisseur de la partie du négatif non protégée par le masque, autrement dit la couronne.

On fournit ci-après un exemple purement illustratif de réalisation du mode de réalisation avantageux du procédé selon l'invention présenté ci-dessus, pour lequel l'épaisseur initiale Ti de la couche 4 (c'est-à-dire après une première étape de préparation de surface, appliquée à une plaquette « fresh ») est de 10 µm (Ti étant généralement compris entre 1 et 50 m).

On considère le prélèvement d'une couche mince d'épaisseur Ts égale à 0,2 m (Ts étant généralement compris entre 0,05 et 0,5 m).

Le prélèvement de la couche mince est réalisé selon un procédé de transfert de type SMARTCUT^{®}, et lors du recyclage, on réalise une élimination de la couronne puis un enlèvement de matière non sélectif de la partie restante 40 de la structure épitaxiée réalisé par polissage de type CMP adapté pour retirer une épaisseur Tr égale à 0,5 m.

Le nombre N de recyclages possibles est alors égal à 13.

## Revendications

1. Procédé de formation d'une structure comportant une couche mince (5, 50) en un matériau semiconducteur sur une plaquette réceptrice (B), comprenant les étapes de :
• préparation (13) de surface par enlèvement d'une épaisseur (Tr) de matière d'une couche (4) formée par croissance épitaxiale sur un substrat support (1) ;
• transfert d'une partie (5, 50) de la couche épitaxiée vers la plaquette réceptrice (B) de manière à former la couche mince sur la plaquette réceptrice, un négatif (A') étant également formé qui comprend le substrat support (1) et une partie restante (40), non transférée, de ladite couche épitaxiée,
**caractérisé en ce que** l'épaisseur (Tr) enlevée par l'étape de préparation de surface est adaptée pour que l'application au négatif (A') de ladite étape de préparation de surface autorise la formation d'une nouvelle couche mince à partir de la partie restante (40) d'épaisseur réduite par l'étape de préparation de surface.

2. Procédé selon la revendication précédente, **caractérisé en ce que** l'enlèvement de matière est un enlèvement non sélectif.

3. Procédé selon la revendication précédente, **caractérisé en ce que** l'enlèvement de matière est un polissage, par exemple de type CMP.

4. Procédé selon la revendication précédente, **caractérisé en ce que** l'enlèvement de matière est compris entre 0,1 et 4 m.

5. Procédé selon l'une des revendications précédentes, **caractérisé en ce que**, avant d'être utilisé pour l'étape de préparation de surface, le négatif est soumis à une étape visant à éliminer une partie d'une couronne de prélèvement (80) correspondant à une partie périphérique de la couche transférée (5, 50) qui est restée solidaire du négatif (A').

6. Procédé selon la revendication précédente, **caractérisé en ce que** l'enlèvement de matière est compris entre 0,1 et 2 m.

7. Procédé selon la revendication précédente, **caractérisé en ce que** l'élimination de la couronne est réalisée par polissage des bords du négatif.

8. Procédé selon l'une des revendications 5 et 6, **caractérisé en ce que** l'élimination de la couronne est réalisée en mettant en oeuvre un enlèvement localisé de matière du négatif, par exemple une gravure plasma localisée.

9. Procédé selon l'une des revendications précédentes dans lequel une plaquette dite donneuse (A) comprend le substrat support (1) sur lequel la couche (4) a été formée par croissance épitaxiale et le transfert comprend les étapes consistant à former (16) une zone de fragilisation (7) dans l'épaisseur de la couche épitaxiée (4), à mettre en contact intime (17) la plaquette donneuse et la plaquette réceptrice et à détacher (18) au niveau de la zone de fragilisation (7), **caractérisé en ce que** suite à sa formation, le négatif (A') est soumis à une étape de traitement thermique de dégazage destinée à faire éclater des microcavités (70) subsistant dans le négatif (A').

10. Procédé selon la revendication précédente, **caractérisé en ce que** le traitement thermique de dégazage est un recuit mené avec un budget thermique supérieur à celui d'un traitement thermique mis en oeuvre pour réaliser l'étape de détachement.

11. Procédé selon la revendication précédente, **caractérisé en ce que** le recuit est mené à une température supérieure à 700 °C.

12. Procédé selon l'une des trois revendications précédentes, **caractérisé en ce qu'**une étape de nettoyage de la surface du négatif (A') est réalisée après le traitement thermique de dégazage.

13. Procédé selon la revendication précédente, **caractérisé en ce que** le nettoyage est du type RCA.

14. Procédé selon l'une des deux revendications précédentes, **caractérisé en ce qu'**une étape de suppression de couche d'oxyde est réalisée suite au nettoyage.

15. Procédé selon la revendication précédente, **caractérisé en ce que** la suppression de couche d'oxyde est réalisée par gravure chimique de type HF.

16. Procédé selon l'une des revendications précédentes dans lequel la couche épitaxiée est une couche (4) en SiGe relaxé formée par croissance épitaxiale sur une couche tampon (3) en SiGe, ladite couche tampon étant formée par croissance épitaxiale sur un substrat support (1) en Si et présentant une composition en Ge augmentant progressivement depuis l'interface avec le substrat support (1), la couche mince transférée comprenant une partie de ladite couche (4) en SiGe relaxé, **caractérisé en ce que** au cours de l'étape de préparation de surface, on réalise un polissage CMP à l'aide d'un tissu de polissage présentant une compressibilité comprise entre 2 et 15% et d'un liquide abrasif contenant au moins 20% de particules de silice ayant une taille comprise entre 70 et 210 nm.

17. Procédé selon l'une des revendications précédentes dans lequel la couche épitaxiée (4, 40) est en SiGe relaxé, **caractérisé en ce que**, suite à l'étape (13) de préparation de surface, il comporte une étape (14) visant à former, par croissance épitaxiale, une surcouche (5) comprenant une couche de Si contraint sur la couche supérieure en SiGe relaxé (4, 40).
